(19) **Europäisches Patentamt / European Patent Office / Office européen des brevets**

(11) **EP 1 751 582 B1**

(12) **EUROPEAN PATENT SPECIFICATION**

(45) Date of publication and mention
of the grant of the patent:
**19.09.2012 Bulletin 2012/38**

(51) Int Cl.:
***G01R 33/3415*** (2006.01)

(21) Application number: **05745653.5**

(22) Date of filing: **03.05.2005**

(86) International application number:
**PCT/US2005/015342**

(87) International publication number:
**WO 2005/109010 (17.11.2005 Gazette 2005/46)**

(54) **MRI POLYHEDRAL COIL ARRAY POSITIONING WITH NON-ZERO GAUSSIAN CURVATURE**

POLYHEDRALE SPULENGRUPPENPOSITIONIERUNG FÜR MRI MIT VON NULL VERSCHIEDENER GAUSSSCHER KRÜMMUNG

POSITIONNEMENT D'UN RESEAU DE BOBINES

(84) Designated Contracting States:
**AT BE BG CH CY CZ DE DK EE ES FI FR GB GR HU IE IS IT LI LT LU MC NL PL PT RO SE SI SK TR**

(30) Priority: **04.05.2004 US 568035 P**

(43) Date of publication of application:
**14.02.2007 Bulletin 2007/07**

(73) Proprietor: **THE GENERAL HOSPITAL CORPORATION**
**Boston, MA 02114 (US)**

(72) Inventors:
- **WIGGINS, Graham, C.**
**Swampscott, MA 01907 (US)**
- **WALD, Lawrence, L.**
**Cambridge, MA 02138 (US)**

(74) Representative: **Gervasi, Gemma et al**
**Notarbartolo & Gervasi GmbH**
**Bavariaring 21**
**80336 München (DE)**

(56) References cited:
**WO-A-02/39135          NL-C2- 1 004 381**
**US-A- 4 825 162         US-A1- 2002 156 362**
**US-A1- 2003 100 826     US-B1- 6 577 888**
**US-B1- 6 727 701**

- **HAMAMURA Y ET AL: "A QD 4-channel Array Coil for fMRI and Brain Imaging" INTERNATIONAL SOCIETY FOR MAGNETIC RESONANCE IN MEDICINE.SCIENTIFIC MEETING AND EXHIBITION. PROCEEDINGS, INTERNATIONAL SOCIETY FOR MAGNETIC RESONANCE IN MEDICINE, US, 24 May 1999 (1999-05-24), page 738, XP007907364 ISSN: 1524-6965**
- **CARVAJAL L ET AL: "Phased array coil design for high resolution imaging of axillary lymph nodes" PROCEEDINGS OF THE INTERNATIONAL SOCIETY FOR MAGNETIC RESONANCE IN MEDICINE, 6TH SCIENTIFIC MEETING AND EXHIBITION, SYDNEY, AUSTRALIA, 18-24 APRIL 1998, 18 April 1998 (1998-04-18), page 439, XP002541467**
- **FITZSIMMONS J R ET AL: "INTEGRATED RF COIL WITH STABILIZATION FOR FMRI HUMAN CORTEX" MAGNETIC RESONANCE IN MEDICINE, ACADEMIC PRESS, DULUTH, MN, US, vol. 38, no. 1, 1 July 1997 (1997-07-01), pages 15-18, XP000694667 ISSN: 0740-3194**
- **YANG X ET AL: "An 8-channel SENSE-optimized phase array neurovascular coil for 3T horizontal system" PROCEEDINGS OF THE INTERNATIONAL SOCIETY FOR MAGNETIC RESONANCE IN MEDICINE, 11TH SCIENTIFIC MEETING AND EXHIBITION, TORONTO, CANADA, 10-16 JULY 2003, 10 July 2003 (2003-07-10), page 2368, XP002541468**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

• BOTTOMLEY P A ET AL: "WHAT IS THE OPTIMUM PHASED ARRAY COIL DESIGN FOR CARDIAC AND TORSO MAGNETIC RESONANCE?" MAGNETIC RESONANCE IN MEDICINE, ACADEMIC PRESS, DULUTH, MN, US, vol. 37, no. 4, 1 April 1997 (1997-04-01), pages 591-599, XP000686622 ISSN: 0740-3194

**Description**

**FIELD OF THE INVENTION**

The invention relates to coil array positioning.

**BACKGROUND OF THE INVENTION**

Magnetic Resonance Imaging (MRI) systems use one or more conductive coils to detect a time-varying magnetic field from a current or voltage across terminals of the coil. Some MRI systems use a "volume coil" such as "birdcage" or "TEM" coil for uniform coverage over a large sample volume. Some MRI systems use a "surface coil" near the surface of a sample for improved sensitivity compared to a volume coil. Surface coils achieve improved sensitivity over a volume similar to the physical dimensions of the surface coil.

Some multi-channel MRI systems use multiple surface coils combined into a "phased array" to provide high sensitivity over larger volumes than are possible with a single surface coil. The elements in a phased array can be arranged in a linear, planar, or cylindrical configuration of overlapping surface coils. Each coil element is coupled to a separate receive channel in the multi-channel MRI system.

Adjacent coil elements can have a "critical overlap" that minimizes the mutual inductance between the adjacent coil elements. Preamplifier decoupling and capacitive decoupling networks can be used to reduce mutual inductance and resulting coil-to-coil interactions among non-adjacent coil elements. Coil elements can be arranged in a row, with each coil element overlapping the next one by the critical amount, to create a linear array (such as a spine array). Additional rows of coil elements can be arranged next to each other overlapping in the second dimension as well to produce a planar array. Such a planar array can be curved into a shape having one dimension of curvature (i.e., curving along only one dimension). For example, a linear or planar array can be wrapped around to form a cylinder used, e.g., as a phased array to image a patient's head. Another type of multi-channel MRI coil is the "gapped array," in which instead of arranging adjacent coil elements to have the critical overlap, coil-to-coil interactions are reduced using techniques such as capacitive decoupling networks. Gapped arrays have been developed primarily to enhance parallel reconstruction techniques such as SENSE, though the same techniques can also be applied with overlapped array coil designs.

For instance, an overlapped array coil design is known from the article by Carvajal L et al, Proceedings of the International Society for Magnetic Resonance in Medicine, p. 439, 1998. This article discloses a coil array according to the preamble of claim 1.

**SUMMARY OF THE INVENTION**

The invention is based, in part, on the recognition that new patterns of coil elements can be arranged on surfaces having Gaussian curvature in an array having a reduced mutual inductance among the coils. Such coil arrays can be used to improve sensitivity in MRI systems significantly.

In one aspect, the invention provides a magnetic resonance imaging RF of coil array as defined in claim 1, Further aspects of the invention are defined in the dependent claims.

The invention provides several advantages. For example, individual coil elements can be arranged on a surface that has non-zero Gaussian curvature while maintaining a critical overlap between coil elements such that mutual inductance is minimized. The sensitivity of the coil array is increased. For embodiments in which coil elements sufficiently wrap around a sample, the sensitivity can exceed that of a volume coil at all points in the sample. Higher sensitivity can provide higher resolution and/or higher imaging speed.

Unless otherwise defined, all technical and scientific terms used herein have the same meaning as commonly understood by one of ordinary skill in the art to which this invention belongs. Although methods and materials similar or equivalent to those described herein can be used in the practice or testing of the present invention, suitable methods and materials are described below. In addition, the materials, methods, and examples are illustrative only and not intended to be limiting.

Other features and advantages of the invention will become apparent from the following description, and from the claims.

**BRIEF DESCRIPTION OF THE DRAWINGS**

FIG. 1 is a block diagram of a multi-channel MRI system.

FIG. 2 is a schematic of coil elements positioned according to a truncated icosahedron arrangement.

FIG. 3 is a set of illustrations of examples of geodesic tilings.

FIGS. 4A and 4B are schematics of models of head coil arrays.

FIG. 5 is a diagram of a head coil array coupled to circuitry.

FIG. 6 is a flowchart for a procedure for arranging coil elements.

FIGS. 7A, 7B, and 7C are a series of diagrams that show front, back and oblique views, respectively, of a model of a coil array for the neck and shoulder.

FIG. 8 is a schematic of pentagonal and hexagonal tiles for coil elements.

FIG. 9 is a pattern of the tiles of FIG. 8.

FIGS. 10A-10C are MRI images of a patient's head taken using an embodiment of the present invention.

FIG. 11A is a set of images taken using an embodiment of the present invention and FIG. 11B is a set of images taken using prior art techniques.

## DETAILED DESCRIPTION

New patterns of coil elements can be arranged on surfaces having Gaussian curvature in an array having a reduced mutual inductance among the coils to improve sensitivity in MRI systems significantly. The coil array can be arranged on a surface having non-zero Gaussian curvature to, for example, surround the head of a human subject to facilitate imaging of the subject's brain with enhanced sensitivity. To cover the surface, an array of coil elements of regular and/or irregular polyhedra are used. The polyhedra chosen to create the coil array depend on the shape of the surface on which they are intended to be arranged, *e.g.*, a head, shoulder, or knee, and various design approaches and geometries are described below.

### Multi-Channel MRI Systems

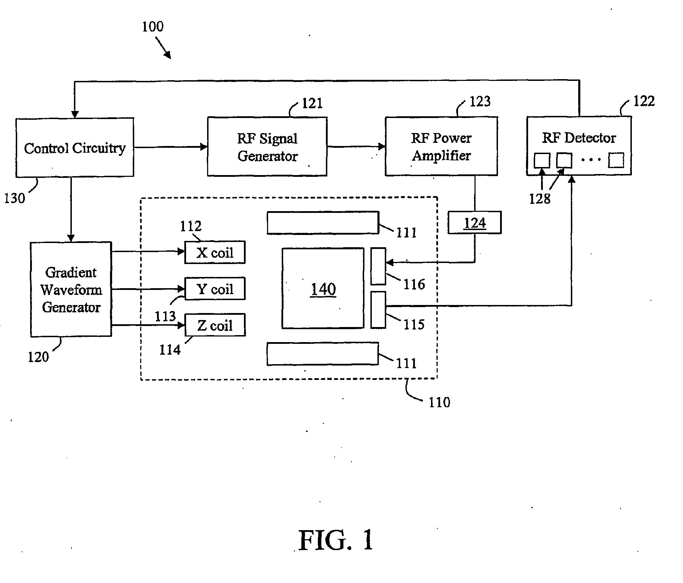

As shown in FIG. 1, a multi-channel MRI system 100 includes a magnetic field assembly 110, interface circuitry 120-124, and control circuitry 130 (e.g., a computer). The magnetic field assembly 110 includes a magnetic field source 111 (e.g., a solenoid) that generates a homogeneous static magnetic field within and around a sample object 140 (e.g., a patient's head). The assembly 110 also includes an X gradient coil 112, a Y gradient coil 113, a Z gradient coil 114, a radio frequency (RF) coil array 115, and an RF transmit coil 116. The RF coil array is positioned proximate to the sample object 140 to receive magnetic resonance signals from the sample object 140 in response to excitation signals provided by the RF transmit coil 116, as described in more detail below.

The interface circuitry 120-124 includes a gradient waveform generator 120 that has signal outputs in communication with terminals of the gradient coils 112-114 and a control input in communication with an output of the control circuitry 130. The control circuitry 130 has another output in communication with an input of an RF signal generator 121 and an input in communication with an RF detector 122. The RF signal generator 121 has an output in communication with an input of an RF power amplifier 123. The RF detector 122 has N channels corresponding to N "active" coil elements in the RF coil array 115. The number of channels N (e.g., 32, 64, etc.) is determined, for example, by the number of receive preamplifiers 128 available in the RF detector 122. The RF coil array 115 may have more than N coil elements, however, only N active coil elements are coupled to the RF detector 122. While the RF detector 122 is receiving magnetic resonance signals from the N active coil elements in the RF coil array 115, a switch 124 is used to isolate the RF transmit coil 116 so that noise in the RF power amplifier 123 does not interfere with reception.

During operation, the multi-channel MRI system 100 builds an image of a portion of the sample object 140 according to a control program executed by the control circuitry 130. The control circuitry 130 generates coordinated signals sent to the gradient waveform generator 120 and to the RF signal generator 121. The RF signal generator 121 generates RF pulses that are amplified by the RF power amplifier 123 and provided to the RF transmit coil 116. The gradient waveform generator 120 generates gradient pulses for the gradient coils 112-114 that coordinate with the RF pulses to provide a magnetic field that excites magnetic spins in a portion of the sample object 140 to be imaged. The MRI system 100 controls the switch 124 to transmit the RF pulses to the RF transmit coil 116 to excite the spins in the sample object 140, and receives the resulting magnetic resonance signals from the RF coil array 115.

Coil elements in the RF coil array 115 are positioned close to the surface of the sample object 140 to be sensitive to the magnetic field generated by the excited spins. One measure of the sensitivity of a coil element, for a given excitation power, is the strength of the received signal divided by the magnitude of the noise. Higher sensitivity generally provides higher resolution, faster imaging, or both.

Coil elements in the RF coil array 115 are also positioned to reduce their mutual inductance so that coil-to-coil interactions are reduced and the signals for the N channels are more independent. Adjacent coil elements overlap by an amount close to the "critical overlap," which is the overlap that minimizes the mutual inductance between the adjacent coil elements. Inductive coupling between coil elements is further reduced by implementing preamplifier decoupling, in which the cable length between a coil element and the corresponding preamplifier and the tuning of the matching circuit into the preamplifier are chosen so that together they transform the high impedance of the preamplifier into a low impedance across the terminals of the coil element. This preamplifier decoupling reduces the amount of current that can flow around the coil and thus helps reduce coupling between next-nearest neighbor coils.

Sensitivity of a coil array tends to increase as the number of (active) individual coil elements in the array increases and the dimensions of the individual coil elements decrease. A large number of coil elements arranged in a hexagonal array can be deformed to cover a (one-dimensionally curved) cylindrical shape, which has zero Gaussian curvature, and retain near critical overlap between adjacent coil elements. However, such a hexagonal array is not readily deformed to cover a surface having non-zero Gaussian curvature while maintaining near critical overlap between adjacent coil elements.

**Coil Arrays for Surfaces Having Non-Zero Gaussian Curvature**

There are many geometric options for arranging coil elements in an array on a surface that has non-zero Gaussian curvature to produce a reduced mutual inductance among the coils. In these geometries, the coil elements overlap over the entire region of interest to reduce the mutual inductance among the coils. Thus, the coil elements may have different orientations with respect to the static magnetic field. If the region of interest is, e.g., the head of a patient lying down in a magnetic resonance scanner, the array includes some coil elements whose normal axis is not substantially perpendicular to the z-axis of the scanner (i.e., the axis in the direction of the static magnetic field). For example, in some embodiments, the array includes coil elements that have a normal axis (i.e., axis normal to the plane of the coil) that is less than 60 degrees from the z-axis. In some embodiments, the array has a coil element whose normal axis is substantially parallel to the z-axis.

The individual coil elements of a coil array over a surface with non-zero Gaussian curvature have positions and normals which correspond to the positions and normals of faces of a portion of a polyhedron, while allowing all coils to overlap with their nearest neighbors such that their mutual inductance is minimized. Some embodiments use particular polyhedra that have properties that are particularly useful for arranging coil arrays. For example, some convex polyhedra having regular convex polygonal faces (e.g., the Platonic Solids and Archimedean Solids) have faces that have an identical geometrical relationship to each neighboring face. This property allows an optimal coil element size chosen for one coil element to apply to other coil elements of the same type.

Polyhedra such as the Platonic Solids (e.g., the dodecahedron) or the Archimedean Solids (e.g., truncated icosahedron) provide patterns of polygons for overlapping coil elements to cover a portion of a spherical or near spherical surface, such as the head. . For some polyhedra, such as polyhedra having faces that are regular convex polygons where no more than three faces meet at each vertex, coil elements can be arranged to cover a spherical or near spherical surface while maintaining near critical overlap between adjacent coil elements.

Another useful property occurs for polyhedra that have a large number (e.g., at least twelve) of faces. This property allows adjacent faces to have a small angle between them so that neighboring coil elements can be nearly co-planar.

In one example, a dodecahedron covers a complete sphere with twelve identical pentagonal faces. A hemispherical coil array can be constructed with approximately six to eight individual coil elements, each having a center coincident with the center of one of the pentagonal faces of a dodecahedron. In this example, each coil element has an identical shape (e.g., a circle or a pentagon) and an identical size chosen to provide the critical overlap between all adjacent coil element pairs.

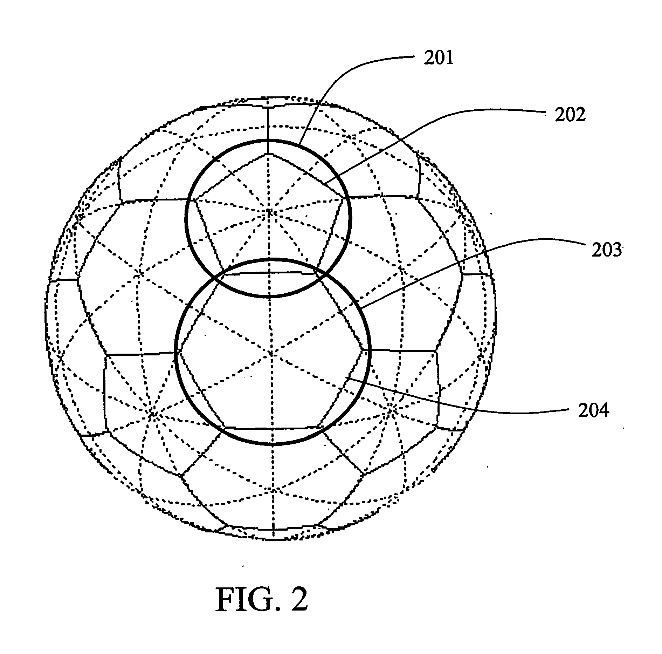

In another example, to incorporate more individual coil elements in a spheroid coil array, a truncated icosahedron (a "soccer ball" shape) arrangement can be used. In such an arrangement, there are twelve pentagonal faces and twenty hexagonal faces over a complete sphere (thirty-two faces in all). As shown in FIG. 2, individual coil elements are arranged centered on the centers of the faces of a portion of a truncated icosahedron that corresponds to the size of the sample object 140. The circumference of a circle circumscribing a pentagonal face is approximately 0.85 times the circumference. of a circle circumscribing a hexagonal face. One arrangement of coil elements in the coil array uses two different sizes of circular coil elements whose relative dimensions are close to this relationship. A first coil element 201 centered on a pentagonal face 202 has a circumference that is approximately 0.85 times the circumference of a second coil element 203 centered on a hexagonal face 204. The absolute sizes of the coil elements are chosen to obtain the critical overlap between the coil elements. A hemispherical coil array can be constructed with approximately sixteen to twenty coil elements.

Sections of the truncated icosahedron arrangement can be used to cover portions of regions of interest in an array for imaging surfaces that resemble a sphere over a particular area of the surface, e.g., the top of the head. A portion of the truncated icosahedron consisting of one pentagon attached to two, three, four or five hexagons (a "soccer-ball sub-unit") is inherently "bowl shaped" and provides non-zero Gaussian curvature to the array. Areas between these sub-units can be tiled with hexagons to form one continuous lattice which defines positions where coil elements can be placed and achieve reduced or minimized mutual inductance. Given a surface on which it is desired to arrange surface coils into an array, if the curvature of the surface locally is less than that of the soccer-ball sub-unit, a new sub-unit may be defined which is derived from the soccer-ball sub-unit by displacing the pentagonal tile until it lies close to the surface, thereby distorting slightly the surrounding hexagonal tiles. Coil elements placed over these distorted hexagons can be distorted similarly to achieve reduced or minimized inductive coupling to neighboring coils.

Other polyhedra can provide a basis for arranging coil elements of a coil array, and more than two sizes of coil elements may be included. In another example, the rhombicosidodecahedron (also known as the "small rhombicosidodecahedron"), which has sixty-two faces over a complete sphere, with pentagonal, square and triangular faces, can be used. A coil array using this arrangement would use three different coil element sizes, corresponding to each of the types of faces. Another useful property occurs for polyhedra that have faces of similar size (e.g., the ratio of the circumferences for two different types of faces is between 3/5 and 5/3, as in the examples described above). This property allows sensitivity to be more uniform over the coil array (since sensitivity tends to vary with coil element size).

A coil element need not have a shape that is precisely a circle or straight-sided polygon. For example, a coil element can have a shape that is derived from a pentagon by replacing the straight sides of a pentagon with arcs or lines having curves. As long as five-way symmetry of such a coil is preserved in a way which provided overlap to reduce, or better mimimize, mutual inductance, such coil elements can also be useful. A generalized tiling of pentagons and hexagons, some of which can be irregular, i.e., have sides of different lengths, can be useful to cover a curved shape.

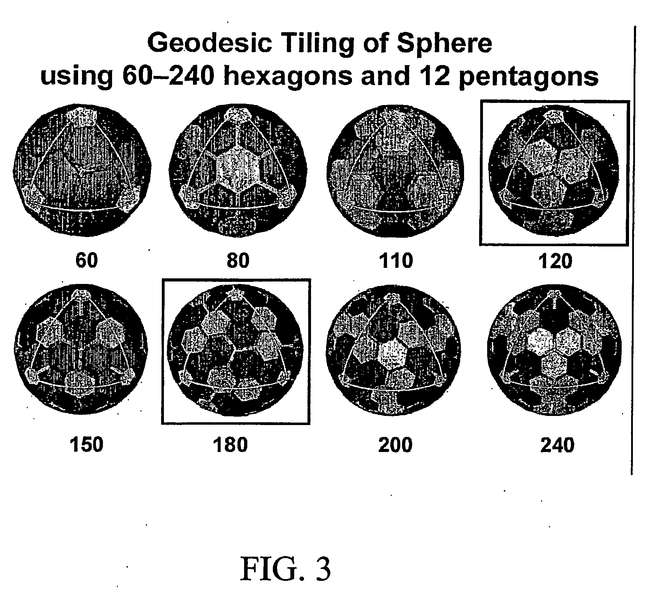

Geodesic tilings are another possible geometry for arranging coil elements. Examples of geodesic tilings are shown in FIG. 3.

### Examples of Coil Arrays for Surfaces with Non-Zero Gaussian Curvature

As described above, faces of a portion of a polyhedron can be used to arrange at least some of the individual coil elements of a coil array over sample objects with non-zero Gaussian curvature, e.g., in an overlapping arrangement. Two or more "sub-arrays" of coil elements (e.g., a pentagon with five surrounding hexagons) can be combined by overlapping neighboring coil elements in the sub-arrays to form a coil array with a desired shape.

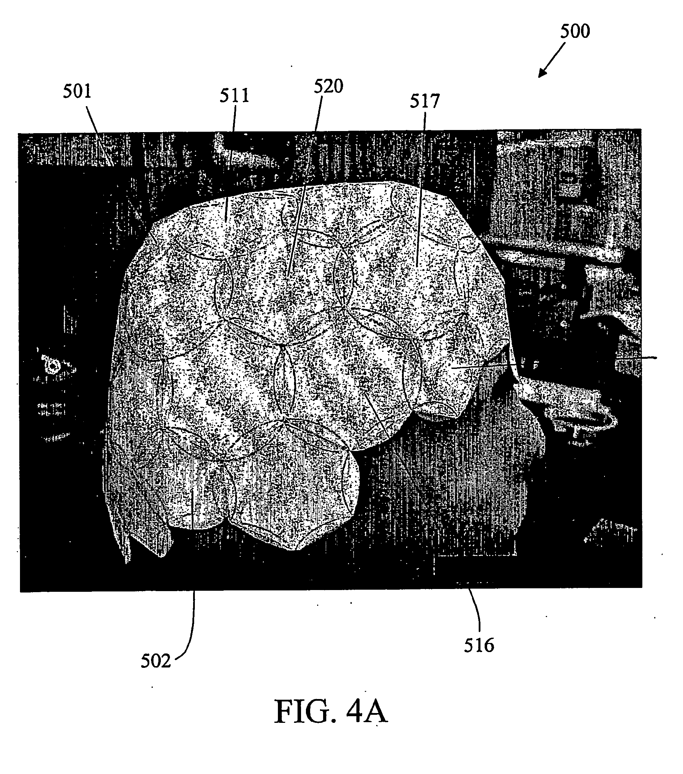

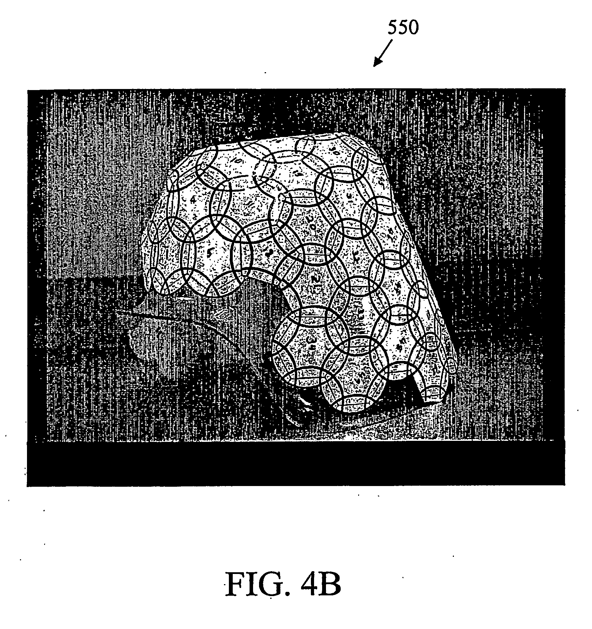

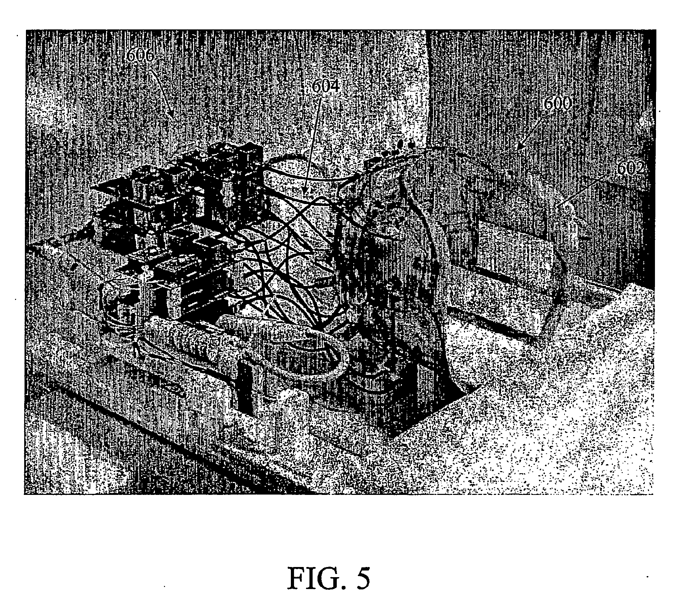

FIG. 4A shows a paper model 400 of an arrangement of forty-eight coil elements in a coil array to image a human head. The model 400 uses pentagonal tiles, e.g., tiles 401 and 403, and hexagonal tiles, e.g., tiles 411 and 417, that are joined together at the edges. FIG. 4B shows a paper model 450 of an arrangement of eighty-four coil elements in a coil array to image a human head. The model 450 also uses pentagonal tiles and hexagonal tiles joined together at the edges. These types of models can be used as a basis for positioning coil elements in an array such as a head coil array 500, shown in FIG. 5. The head coil array 500 has twenty-three coil elements arranged on a helmet structure 502 for imaging a human head. The head coil array 500 is coupled by wires 504 to circuitry 506.

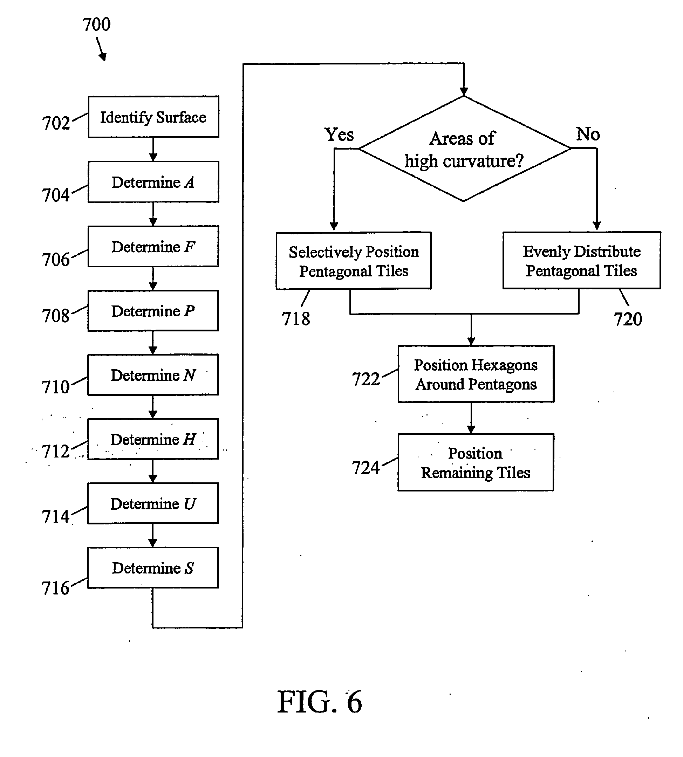

FIG. 6 shows a flowchart for an exemplary procedure 600 to construct a coil array to cover a portion of a sample object with non-zero Gaussian curvature. A surface to be covered by the coil array is identified 602. After the surface is identified, the surface area A of the surface is determined 604 (e.g., from direct measurements of a sample object or calculated estimates). A "fractional curvature" $F$ of the surface is also determined 606, by comparing the surface to a complete sphere ($F = 1$). For example, a coil array for imaging a head may use a surface corresponding to a hemisphere or half of a sphere with F = 0.5. A coil array for imaging a shoulder may use a surface corresponding to a quarter of a sphere with $F = 0.25$.

In this procedure 600, the arrangement of individual coil elements is based on combining pentagonal tiles and hexagonal tiles. Adding a pentagonal tile to a hexagonal array introduces a Gaussian curvature of approximately 12 degrees. A complete sphere can for example be covered with twelve pentagonal tiles and twenty hexagonal tiles (arranged as a truncated icosahedron). The procedure 600 includes determining 608 an approximate number of pentagonal tiles P to be used for the selected surface: $P \approx 12 \times F$. This number can be rounded up or down to the nearest integer. For a hemispherical coil array, $P = 12 \times 0.5 = 6$. The procedure 600 also includes determining 610 a number of detector channels N that are available. An approximate number of hexagonal tiles $H$ to be used for the selected surface is determined 612 based on this number of channels $N$: $H = N - P$.

These quantities are used to determine 614 a "unit-tile surface area" $U$ as follows:

$$U = (H \times 2.598) + (P \times 1.720).$$

The quantity 2.598 is the approximate area of a hexagonal tile with sides of length 1. The quantity 1.720 is the approximate area of a pentagonal tile with sides of length 1. For an approximately hemispherical head coil array with 96 channels ($N = 96$), the unit-tile surface area is

$$U = (90 \text{ x } 2.598) + (6 \text{ x } 1.720) = 244.14.$$

A scaling factor S is determined 616 as the ratio $S = A / U$. The length of the sides of the pentagonal and hexagonal tiles used to cover the selected surface for arranging coil elements is L = √S. Using a calculated surface area $A$ = 107,832 mm$^2$ for the 96-channel head coil array, the tile side length $L$ = 21.02 mm.

After the number and size of tiles is determined, a model for the coil array can be constructed (e.g., using paper, plastic, or other materials), or a model for the coil array can be designed using three-dimensional computer-aided design (CAD) software or other computer graphics tool. For example, if the selected surface has portions having relatively high curvature compared to the rest of the surface, the procedure 600 includes positioning 618 some of the pentagonal tiles near locations having relatively high curvature, such as near the top of the head (e.g., tiles 401-403, FIG. 4A). If the surface has a relatively uniform curvature, then the pentagonal tiles should be evenly distributed 620 over the surface. Starting with one pentagonal tile, some hexagonal tiles are positioned edge-to-edge 622 around it (e.g., tile 416 and tile 417, FIG. 4A) in an arrangement that corresponds to a portion of a truncated icosahedron. Depending on the shape of the surface, the hexagonal tiles may be deformed (e.g., bent or warped) to fit into place. Some hexagonal tiles are positioned edge-to-edge between other hexagonal tiles (e.g., tile 420, FIG. 4A). Additional hexagonal tiles are added to the tiling pattern until the position of another pentagonal tile is approached.

The final position and orientation of each additional pentagonal tile incorporated into the tiling pattern will typically have to be adjusted so that it can match edge-to-edge with the tiles already placed. Any remaining pentagonal or hexagonal tiles can be positioned 624 in the model (and deformed if necessary) in a way such that the model conforms to the local curvature of the selected surface as closely as possible. If the only deformations are warping of the tiles such that the lengths of the sides remain the same, the overall size and shape of the tiles will remain almost unchanged compared to flat regular hexagons or pentagons, simplifying the coil placement procedure. If the curvature of the "soccerball element" is much higher than the local curvature of the surface, the tiling pattern may not conform as closely to the surface as desired. In this case, the pattern can be mapped onto the surface, effectively moving a tile that is not close enough to the surface inwards or outwards until it lies on the surface, which requires shortening some of the sides of some of the tiles. While tiles distorted in this way may not be effectively identical in size and shape to regular hexagons or pentagons, they can still provide the basis for a coil array with reduced or minimized mutual inductance between neighboring coils.

Such a model can serve as a guide for positioning the coil elements used for the coil array. The individual coil elements can be constructed from a combination of conductive material and capacitors. For example, a loop of circuit board or copper tape is broken in several places and these breaks are bridged with capacitors. The resulting effective inductance and capacitance of the loop determine the resonant frequency of the loop. This resonant frequency is tuned to the operating frequency of the MRI system 100 (e.g., 63.4 MHz for a system using a 1.5 Tesla magnetic field source, or 123.3 MHz for a system using a 3 Tesla magnetic field source).

The coil elements are arranged with their respective centers corresponding to the center of a tile. The relative size of the coil elements are selected to correspond to the relative sizes of the tiles, and the absolute size of the coil elements are selected to provide a coil element overlap close to the critical overlap, as described above. The shape of a coil element can be round, or alternatively, the shape of a coil element can correspond to the shape (e.g., pentagonal or hexagonal) of the tile according to which it is placed. The shape of a coil element may also be deformed to match the model. The exact position and/or shape of the coil elements can optionally be optimized empirically or by computer modeling to match the surface well and maintain reduced mutual inductance among the coil elements. The head coil array 500 includes 23 active coil elements ($N$ = 23) over an approximately hemispherical surface with $L$ = 44 mm. The circular coil elements placed on positions of hexagonal tiles have a diameter of approximately 98 mm, and the circular coil elements placed on positions of pentagonal tiles have a diameter of approximately 73 mm.

Other procedures for arranging the coil elements of a coil array over sample objects with non-zero Gaussian curvature are possible. For example, other tile shapes (e.g., triangles, squares, octagons) can be used to generate a model of a surface based on portions of a polyhedron having an appropriate shape (i.e., a shape that allows coil elements to be positioned as close as possible to the selected surface). Coil elements can be arranged on a surface that has locally negative Gaussian curvature (a saddle shape) by incorporating a heptagonal (7-sided) tile at the points of maximum negative curvature. Introducing a heptagonal tile into a hexagonal array introduces a Gaussian curvature of about -8.5 degrees.

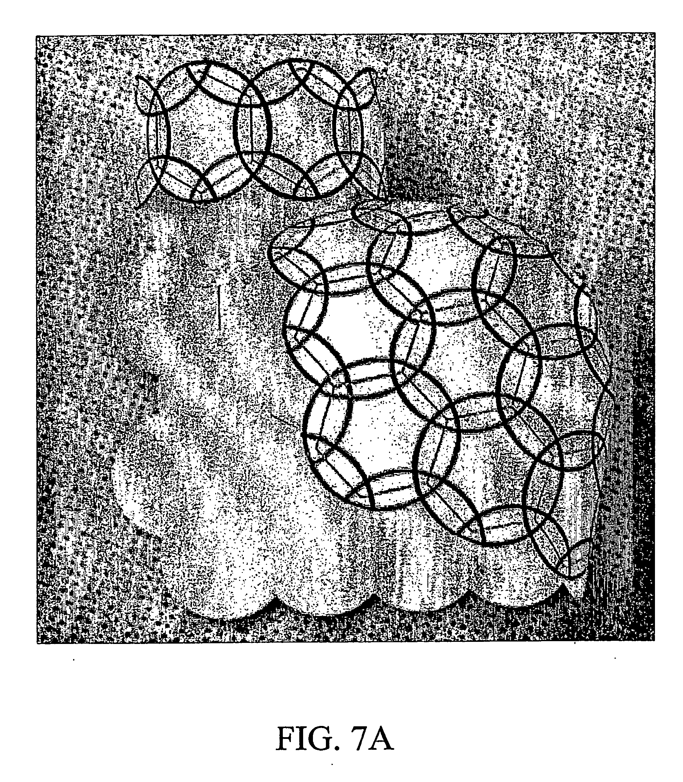

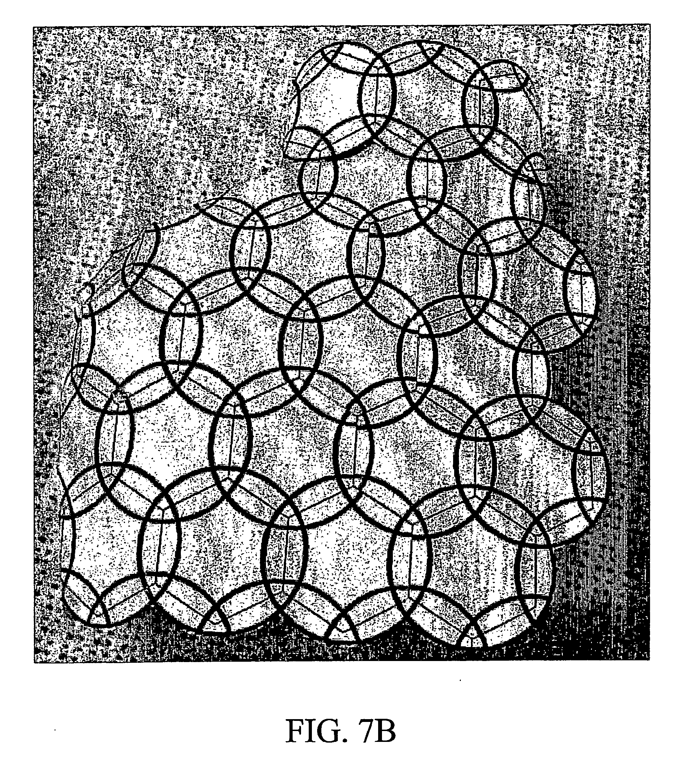

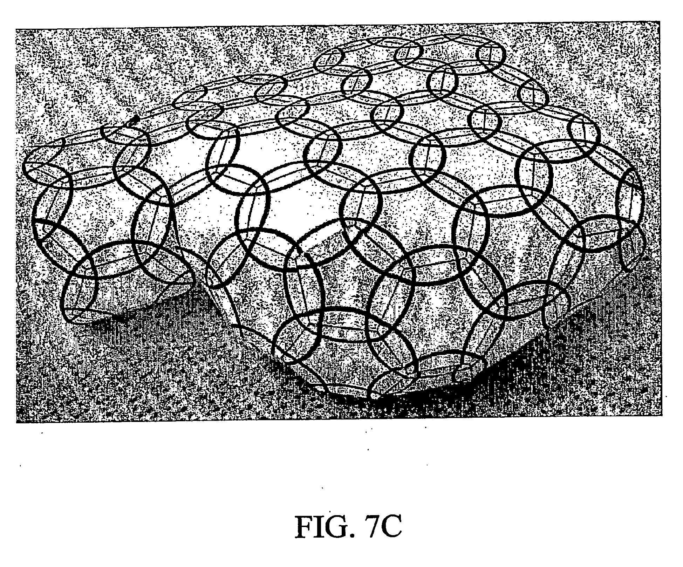

Some sample objects may have a surface with a complex form that includes multiple curved features. The procedure 600 described above can be used to generate multiple models for the various features. The models can then be connected by matching edges of polygonal tiles. For example, a model for a coil to cover a patient's shoulder and neck may include a first portion curved in one direction to cover the shoulder and a second portion connected to the first portion curved in a different direction to cover the neck. FIGs. 7A, 7B, and 7C show various views of a model of such a coil. Other complex forms may include relatively flat surfaces. For example, a model for a coil to cover a patient's knee may include one or more curved portions to cover the top of the knee and two flat portions connected to the curved portions to cover the sides of the knee.

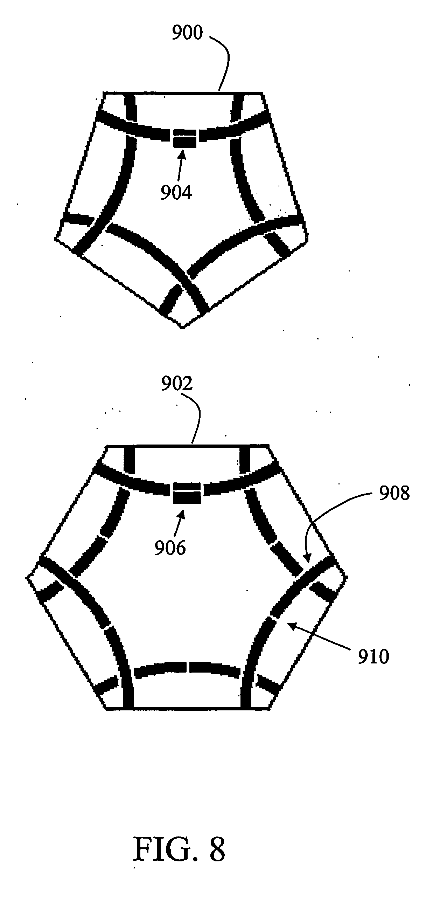

Coil elements are formed using conductive material on insulating flexible printed circuit board tiles. FIG. 8 shows a layout 800 for a pentagonal tile having five overlapping portions of conductive coil elements, and a layout 802 for a hexagonal tile having six overlapping portions of conductive coil elements. A complete coil element can be formed, for example, by portions from six tiles surrounding a hexagonal tile or by portions from five tiles surrounding a pentagonal tile. Such coil elements have an approximately circular shape, though are not completely planar. The intersection 808 of coil elements is insulated so that overlapping coils are not in electrical contact. Gaps in a coil element provides locations for terminals 804 and 806 to interface with a coil element. A coil element may also include other gaps, such as gap 810 (e.g., for insertion of capacitors).

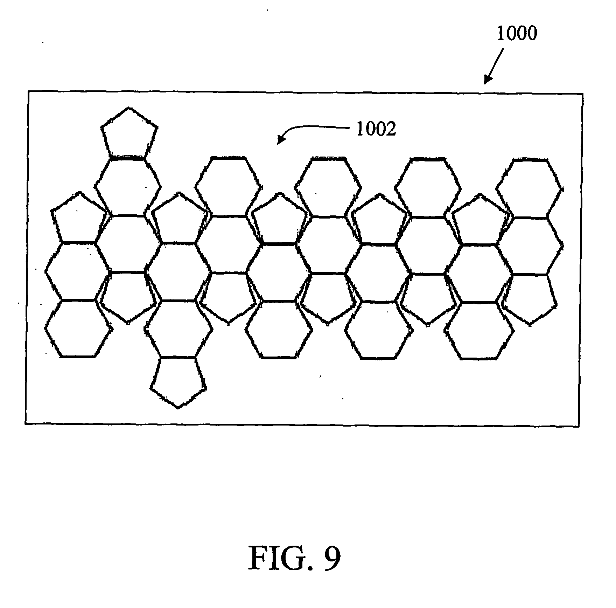

Such pentagonal and hexagonal tiles can be manufactured individually, or as part of a larger form. For example, as shown in FIG. 9, a flexible circuit board 900 includes a pattern 902 of tiles connected in to form a truncated icosahedron. Alternatively, a subset of this pattern 902 or a pattern corresponding to some other polyhedron can be included on a circuit board to form a hemisphere or other curved shape. This shape can then be applied to the surface that has non-zero Gaussian curvature.

Patterns of coil elements can also be connected to form a "chain mail" coil array for draping over a portion of a patient's body. Each coil element can be created from a durable material (e.g., G10 circuit board) and then "riveted" together with plastic or other non-conductive magnetic resonance compatible clips at the points where they cross. With particular curvature built in to the chain mail coil array (e.g., to drape around the neck and over the torso), it will still have sufficient flexibility to conform to the patient's body and keep the coil elements as close as possible to the body for maximum sensitivity.

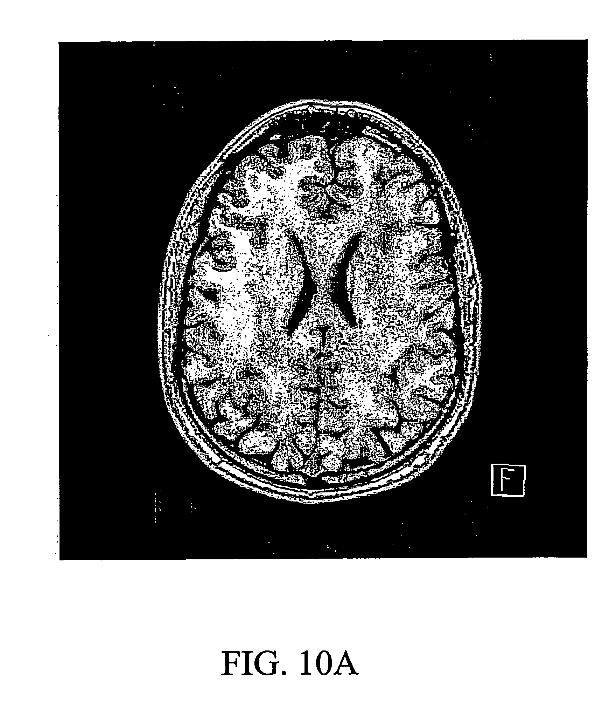

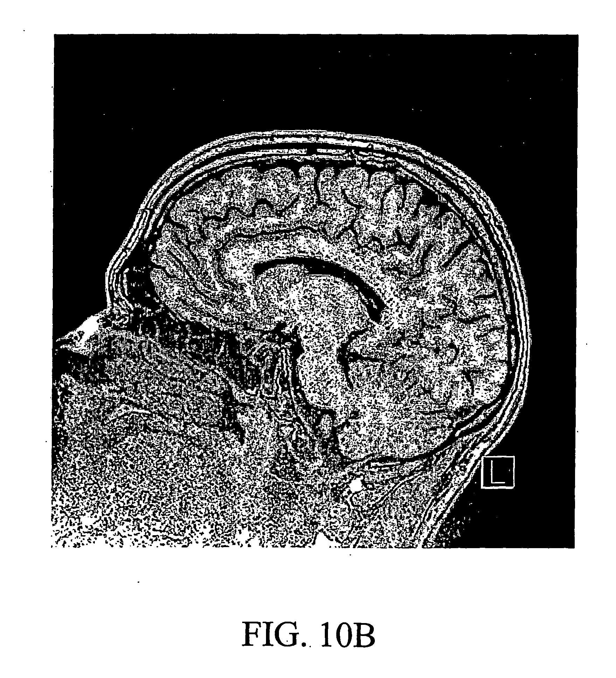

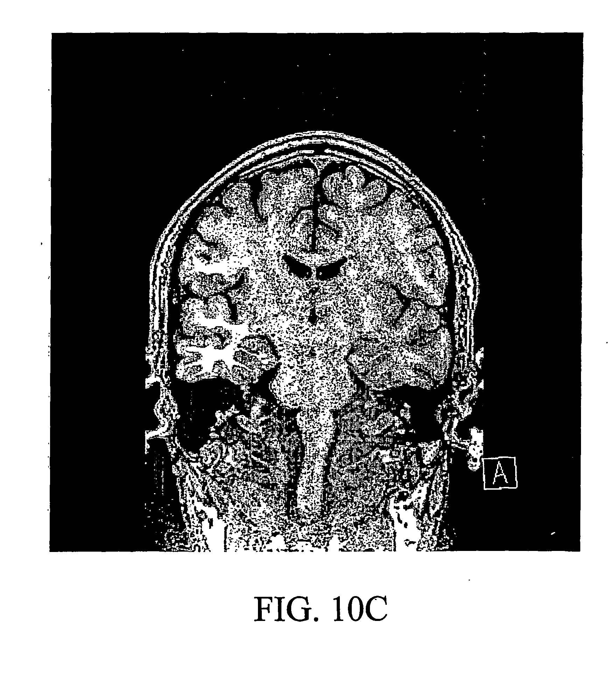

FIG. 10A shows an MRI image of an axial slice through the middle of a subject's brain taken with a multi-channel MRI system including a 23-channel head coil array (as shown in FIG. 5) constructed as described herein. FIG. 10B shows an MRI image of a sagittal slice through the middle of a subject's brain taken with the same system. FIG. 10C shows an MRI image of a coronal slice through the middle of a subject's brain taken with the same system. These images shown in FIGS. 10A-10C demonstrate the sensitivity of the coil array to the entire volume encompassed by the coil array (i.e., the whole brain). The images shown in FIGS 10A - 10C are different slices through a three-dimensional data set obtained with a standard mprage sequence with TR = 2000 ms, TE = 2.8 ms, TI = 1000 ms, Flip Angle 10 degrees, and resolution 1 mm isotropic, and they have been intensity normalized to correct for the sensitivity profile of the head coil array.

### Comparative Imaging

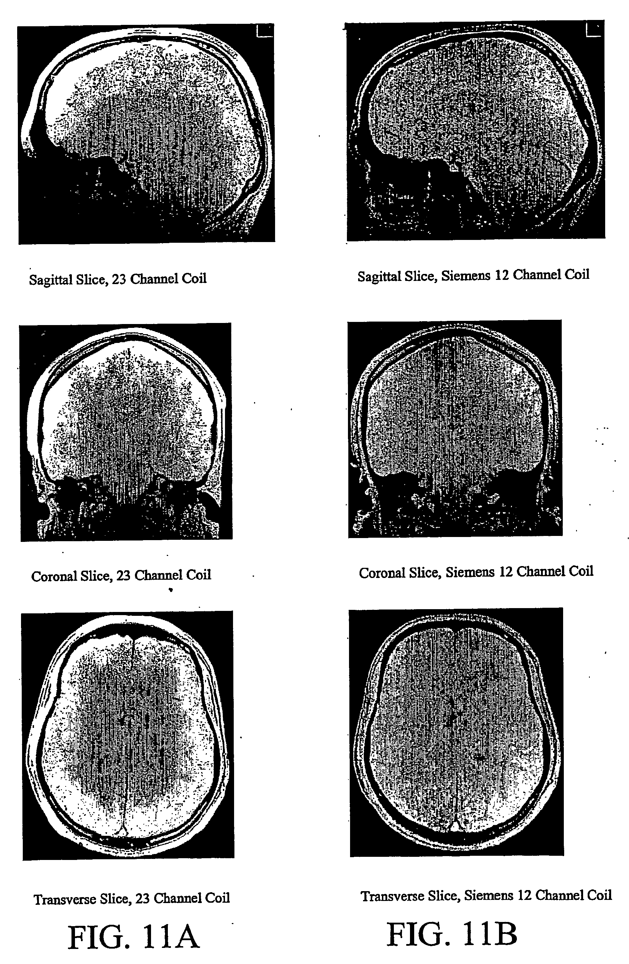

Images taken using an embodiment of the present invention are shown in FIG. 11A and images taken using prior art techniques are shown in FIG. 11B for comparison. All images in 11A and 11B were obtained with identical scan parameters, using a gradient echo sequence with TR = 200 ms, TE = 3.92 ms, Flip Angle 20 degrees, slice thickness 2.5 mm, image matrix = 256 x 256 and field of view = 200mm. Image brightness scales approximately with signal-to-noise ratio (SNR), and the gray scales have been set to yield similar gray values near the center of the head where statistical analyses of the images shows the two head coils have similar SNR.

### OTHER EMBODIMENTS

It is to be understood that while the invention has been described in conjunction with the detailed description thereof, the foregoing description is intended to illustrate and not limit the scope of the invention, which is defined by the scope of the appended claims. Other aspects, advantages, and modifications are within the scope of the following claims.

### Claims

1. A magnetic resonance imaging RF coil array comprising:

   a plurality of conductive coil elements adapted to be coupled to an RF detector of an MRI system,
   each coil element being a resonant loop having a conductive trace,
   **characterized in that**
   the conductive trace of each coil element being formed using conductive material on flexible printed circuit board tiles,
   each of the tiles having a polygonal shape with a plurality of edges,

the center of each of the conductive traces being located at the center of one of the polygonal tiles,
the polygonal tiles being positioned with respect to one another in such a manner that (i) the conductive trace of each of the coil elements is arranged so that its center and normal correspond to the center and normal of a face of a polyhedron, that (ii) the portion of the polyhedron covered by the plurality of coil elements has a non-zero Gaussian curvature and that (iii) the conductive traces of nearest neighboring coil elements overlap such that their mutual inductance is reduced;
wherein, for each of the coil elements, its conductive trace is formed by conductive trace portions located on the plurality of tiles surrounding the polygonal tile whose center is located at the center of the conductive trace of said coil element.

2. The coil array of claim 1, wherein the polygonal tiles are positioned such that said mutual inductance is minimized.

3. The coil array of claim 1, wherein the portion of the polyhedron has faces whose sides have unequal length.

4. The coil array of claim 1, wherein the magnitude of the Gaussian curvature is at least eight degrees.

5. The coil array of claim 4, wherein the coil elements are of similar size.

6. The coil array of claim 4, wherein the ratio of the circumference of any two coil elements is equal to or greater than 3/5, and less than or equal to 5/3.

7. The coil array of claim 4, wherein the magnitude of the Gaussian curvature is at least 50 degrees.

8. The coil array of claim 4, wherein the portion of the polyhedron conforms to the surface of a helmet.

9. The coil array of claim 4, wherein each coil element defines an area that is less than one-sixteenth of the total area of the portion of the polyhedron.

**Patentansprüche**

1. Magnetresonanz-Bildgebungs-HF-Spulenanordnung, die umfasst:

mehrere leitende Spulenelemente, die dafür ausgelegt sind, mit einem HF-Detektor eines MRI-Systems gekoppelt zu werden,
wobei jedes Spulenelement ein Resonanzkreis mit einer Leiterbahn ist,
**dadurch gekennzeichnet, dass**
die Leiterbahn jedes Spulenelements unter Verwendung von leitendem Material auf Kacheln flexibler gedruckter Schaltungen gebildet ist,
wobei jede der Kacheln eine mehreckige Form mit mehreren Kanten aufweist,
wobei sich die Mitte jeder der Leiterbahnen in der Mitte einer der mehreckigen Kacheln befindet,
wobei die mehreckigen Kacheln in Bezug zueinander in der Weise positioniert sind, dass (i) die Leiterbahn jedes der Spulenelemente so angeordnet ist, dass ihre Mitte und ihre Normale der Mitte und der Normale einer Fläche eines Polyeders entsprechen, dass (ii) der von den mehreren Spulenelementen bedeckte Abschnitt des Polyeders eine von null verschiedene Gauß'sche Krümmung aufweist und dass (iii) sich die Leiterbahnen am nächsten benachbarter Spulenelemente überschneiden, sodass ihre Gegeninduktion verringert ist;
wobei für jedes der Spulenelemente seine Leiterbahn durch Leiterbahnabschnitte gebildet ist, die sich auf den mehreren Kacheln befinden, die die mehreckige Kachel, deren Mitte sich in der Mitte der Leiterbahn des genannten Spulenelements befindet, umgeben.

2. Spulenanordnung gemäß Anspruch 1, bei der die mehreckigen Kacheln in der Weise positioniert sind, dass ihre genannte Gegeninduktion minimiert ist.

3. Spulenanordnung gemäß Anspruch 1, bei der der Abschnitt des Polyeders Flächen aufweist, deren Seiten unterschiedliche Längen aufweisen.

4. Spulenanordnung gemäß Anspruch 1, bei der der Betrag der Gauß'schen Krümmung wenigstens acht Grad ist.

**5.** Spulenanordnung gemäß Anspruch 4, bei der die Spulenelemente eine ähnliche Größe aufweisen.

**6.** Spulenanordnung gemäß Anspruch 4, bei der das Umfangsverhältnis zweier beliebiger Spulenelemente gleich oder größer als 3/5 ist und kleiner oder gleich 5/3 ist.

**7.** Spulenanordnung gemäß Anspruch 4, bei der der Betrag der Gauß'schen Krümmung wenigstens 50 Grad ist.

**8.** Spulenanordnung gemäß Anspruch 4, bei der der Abschnitt des Polyeders an die Oberfläche eines Helms angepasst ist.

**9.** Spulenanordnung gemäß Anspruch 4, bei der jedes Spulenelement eine Fläche definiert, die kleiner als ein Sechzehntel der Gesamtfläche des Abschnitts des Polyeders ist.


**Revendications**

**1.** Réseau de bobines RF d'imagerie par résonance magnétique comprenant :

une pluralité d'éléments formant bobines conductrices conçus pour être couplés à un détecteur RF d'un système IRM,
chaque élément formant bobine étant une boucle résonante ayant une trace conductrice,
**caractérisé en ce que**
la trace conductrice de chaque élément formant bobine est formée au moyen d'un matériau conducteur sur des plaquettes flexibles de circuits imprimés,
chacune des plaquettes ayant la forme d'un polygone avec une pluralité de bords,
le centre de chacune des traces conductrices étant situé au centre d'une des plaquettes polygonales,
les plaquettes polygonales étant placées les unes par rapport aux autres d'une manière telle que (i) la trace conductrice de chacun des éléments formant bobines est agencée de sorte que son centre et sa perpendiculaire correspondent au centre et à la perpendiculaire d'une face d'un polyèdre, que (ii) la partie du polyèdre couverte par la pluralité d'éléments formant bobines a une courbure de gausse non nulle et que (iii) les traces conductrices des éléments formant bobines voisins les plus proches se chevauchent de sorte que leur inductance mutuelle est réduite ;
dans lequel, pour chacun des éléments formant bobines, sa trace conductrice est formée par des parties de trace conductrice situées sur la pluralité de plaquettes entourant la plaquette polygonale dont le centre se trouve au centre de la trace conductrice dudit élément formant bobine.

**2.** Réseau de bobines selon la revendication 1, dans lequel les plaques polygonales sont placées de telle sorte que ladite inductance mutuelle est réduite.

**3.** Réseau de bobines selon la revendication 1, dans lequel la partie du polyèdre a des faces dont les côtés sont de longueur inégale.

**4.** Réseau de bobines selon la revendication 1, dans lequel la magnitude de la courbe de Gauss est d'au moins huit degrés.

**5.** Réseau de bobines selon la revendication 4, dans lequel les éléments formant bobines sont de taille similaire.

**6.** Réseau de bobines selon la revendication 4, dans lequel le rapport de la circonférence de deux éléments quelconques formant bobines est égal ou supérieur à 3/5, et inférieur ou égal à 5/3.

**7.** Réseau de bobines selon la revendication 4, dans lequel la magnitude de la courbe de Gausse est d'au moins 50 degrés.

**8.** Réseau de bobines selon la revendication 4, dans lequel la partie du polyèdre épouse les contours de la surface d'un casque.

**9.** Réseau de bobines selon la revendication 4, dans lequel chaque élément formant bobine délimite une zone qui est inférieure à un seizième de la surface totale de la partie du polyèdre.

100

121     123     122

| Control Circuitry | | RF Signal Generator | | RF Power Amplifier | | RF Detector |

130

112
X coil

Gradient Waveform Generator

Y coil

113     Z coil

120     114

111

124

140     116

115

110

128

**FIG. 1**

FIG. 2

# Geodesic Tiling of Sphere
# using 60–240 hexagons and 12 pentagons

| | | | |
|---|---|---|---|
| 60 | 80 | 110 | 120 |
| 150 | 180 | 200 | 240 |

FIG. 3

FIG. 4A

550

FIG. 4B

FIG. 5

700

702 — Identify Surface

704 — Determine $A$

706 — Determine $F$

708 — Determine $P$

710 — Determine $N$

712 — Determine $H$

714 — Determine $U$

716 — Determine $S$

Areas of high curvature?

Yes — Selectively Position Pentagonal Tiles — 718

No — Evenly Distribute Pentagonal Tiles — 720

722 — Position Hexagons Around Pentagons

724 — Position Remaining Tiles

FIG. 6

FIG. 7A

FIG. 7B

FIG. 7C

FIG. 8

1000

1002

FIG. 9

FIG. 10A

FIG. 10B

FIG. 10C

Sagittal Slice, 23 Channel Coil

Sagittal Slice, Siemens 12 Channel Coil

Coronal Slice, 23 Channel Coil

Coronal Slice, Siemens 12 Channel Coil

Transverse Slice, 23 Channel Coil

Transverse Slice, Siemens 12 Channel Coil

FIG. 11A

FIG. 11B

**EP 1 751 582 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **CARVAJAL L et al.** *Proceedings of the International Society for Magnetic Resonance in Medicine,* 1998, 439